Europäisches Patentamt

**European Patent Office**

**Office européen des brevets**

(11) Numéro de publication: **0 161 173**

**A1**

(12)

# DEMANDE DE BREVET EUROPEEN

(21) Numéro de dépôt: **85400725.9**

(22) Date de dépôt: **11.04.85**

(51) Int. Cl.⁴: **H 01 S 3/19**
**H 01 L 33/00**

(30) Priorité: **13.04.84 FR 8405878**

(43) Date de publication de la demande:
**13.11.85 Bulletin 85/46**

(84) Etats contractants désignés:
**DE GB NL**

(71) Demandeur: **SAT Société Anonyme de Télécommunications**
**41, rue Cantagrel**
**F-75631 Paris Cedex 13(FR)**

(72) Inventeur: **Brouard, Lydie**
**41, rue Cantagrel**
**F-75631 Paris Cédex 13(FR)**

(72) Inventeur: **Corcier, Jeanne Pascale**
**41, rue Cantagrel**
**F-75631 Paris Cédex 13(FR)**

(72) Inventeur: **Papageorgiou, Georges**
**41, rue Cantagrel**
**F-75631 Paris Cédex 13(FR)**

(74) Mandataire: **Bloch, Robert et al,**
**39 avenue de Friedland**
**F-75008 Paris(FR)**

(54) Diode laser à confinement électrique par jonction iverse.

(57) Elle comporte une jonction inverse N-P-N du type thyristor en InP (1, 2, 7), en dessous de trois autres couches (9, 11, 12) respectivement en In Ga A$_x$ P, InP, In Ga A$_x$ P. Un canal en V (5) s'étend depuis légèrement en dessous de la jonction N-P (1, 2) jusqu'à la couche (9) en In Ga A$_x$ P. Dans le canal (5), sur un fond en InP, s'étend une couche active enterrée (10) en forme de croissant, en In Ga A$_x$ P. Les zones latérales (13) des couches (11, 12), de part et d'autre du canal (5) sont implantées de protons. Le confinement latéral du canal laser de la diode est renforcé. Elle émet un rayonnement de 1,3 μm de longueur d'onde, notamment pour les télécommunications par fibres optiques.

FIG.5

EP 0 161 173 A1

La présente invention concerne une diode laser à confinement électrique par jonction inverse, comprenant une première jonction, formée par un substrat semi-conducteur, de l'un des deux types de conductivité N et P, et une première couche de l'autre des deux types, une deuxième jonction, formée par ladite première couche et une deuxième couche du même type que le substrat, un canal en forme de V, et, enterrée dans le canal en V, au-dessus d'un fond identique à ladite deuxième couche, une couche active en forme de croissant.

On connaît donc déjà des diodes laser à couche active en forme de croissant enterré, c'est-à-dire des diodes laser à guidage par l'indice, dans lesquelles le confinement électrique latéral du canal laser, c'est-à-dire encore la canalisation des lignes de courant sur une très faible largeur, est obtenu par jonction inverse du type thyristor.

Par une telle jonction inverse, on entend, rappelons-le, une double jonction de type N-P et P-N, formant ainsi une jonction inverse P-N-P ou, de préférence, N-P-N. Dans ces diodes, la couche active en croissant est enterrée dans un canal en forme de V, dont le dièdre s'étend légèrement en dessous du niveau de la première jonction réalisée avec un substrat semi-conducteur de l'un des deux types N et P, de préférence N, et au-dessus d'un fond du même type que le substrat, les parois latérales du canal en V s'étendant au-delà du niveau de la deuxième jonction réalisée avec la première couche de la première jonction de l'autre des deux types et une deuxième couche du même type que le substrat.

Ces diodes laser à guidage par l'indice sont notamment utilisées dans les télécommunications par fibres optiques pour émettre un rayonnement de 1,3 $\mu$m de longueur d'onde et elles sont avantageusement des diodes en InGaAsP/InP.

Si le confinement électrique par jonction inverse du type thyristor permet donc une canalisation des lignes de courant sur une très faible largeur, de l'ordre de 2 $\mu$m, il est par contre peu fiable à cause des risques de claquage de la jonction N-P-N.

La présente invention vise à éliminer ces risques.

A cet effet, la présente invention concerne une diode laser à confinement électrique par jonction inverse du type mentionné ci-dessus, caractérisée par le fait que les portions de la diode disposées latéralement de part et d'autre du canal en V et de l'autre côté de celui-ci par rapport au substrat sont implantées de protons.

Certes, on connaissait déjà des diodes laser dans lesquelles le confinement électrique latéral du canal laser est obtenu par bombardement protonique. Il s'agit aussi de diodes à guidage par l'indice. Mais l'invention n'en demeure pas moins remarquable car, si ces diodes présentent une relativement bonne fiabilité, elles ne permettent pas de canaliser l'injection des porteurs sur des dimensions aussi faibles que dans les diodes à confinement par jonction inverse, si bien que l'homme de métier était naturellement dissuadé de tenter de combiner les deux technologies.

Grâce à l'invention, on obtient des diodes laser à double confinement électrique, ou à confinement électrique renforcé, permettant d'atteindre des rendements élevés tout en présentant une fiabilité tout à fait satisfaisante.

L'invention sera mieux comprise à l'aide de la description suivante d'une forme de réalisation préférée de la diode laser de l'invention, en référence aux dessins annexés représentant les différentes étapes de fabrication de la diode laser de l'invention, et sur lesquels :

La figure 1 représente une vue schématique d'une plaquette de diodes de l'invention en cours de fabrication, après formation de la première jonction N-P;

la figure 2 représente la plaquette de la figure 1, juste avant la formation des canaux en V;

la figure 3 représente la plaquette de la figure 2, après formation des canaux en V;

la figure 4 représente la plaquette de la figure 3, après l'élimination de la couche de masquage, et

la figure 5 représente la métallurgie de la plaquette une fois terminée, après l'implantation protonique.

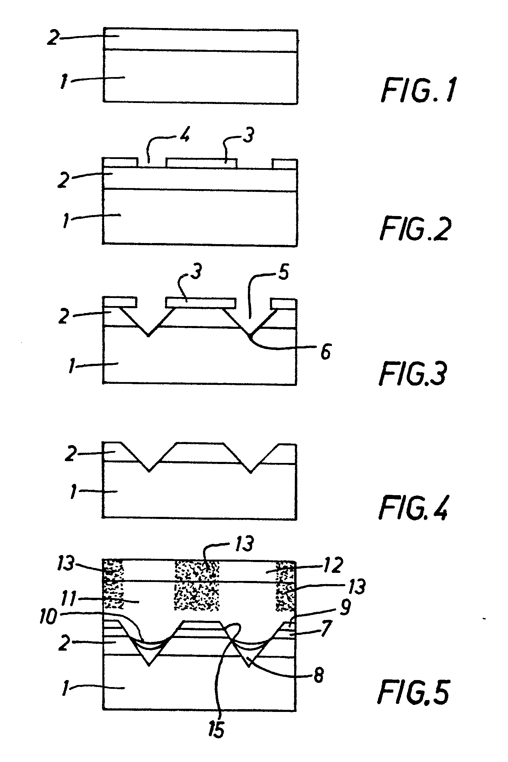

Les différentes étapes de la fabrication de diodes laser selon l'invention sont illustrées par les figures 1-5. Il s'agit en fait de la fabrication de plaquettes de mosaïques de diodes dont le clivage permet d'obtenir des diodes élémentaires, ou puces, en l'occurrence d'environ 250 $\mu$m de côté.

Seule la métallurgie des plaquettes épitaxiées sera décrite ici, la technologie des étapes ultérieures de montage étant au demeurant classique et bien connue de l'homme de métier.

Il s'agit ici de diodes en InGaAsP/InP à 1,3 $\mu$m.

Sur un substrat 1, ici en phosphure d'indium de type N, InP-N, préalablement décapé chimiquement, on dépose une première couche 2 de InP de type P d'environ 1,5 $\mu$m d'épaisseur, par épitaxie en phase liquide (figure 1). On obtient ainsi une première jonction N-P.

On procède ensuite, à très faible température, à un dépôt pyrolitique 3 de $SiO_2$ sur toute la plaquette, pour former une couche de masquage. Puis on effectue une opération classique de photogravure, pour ménager des ouvertures 4 dans la couche 3 (figure 2).

Par les ouvertures 4, on procède à une attaque chimique de la couche 2 et même légèrement du substrat 1, pour former des gorges ou canaux 5 en forme de V, d'environ 3 $\mu$m de largeur et 1,5 $\mu$m de profondeur (figure 3). La conformation en V des canaux résulte de l'emploi d'une solution d'attaque sélective et de la structure cristallographique du matériau semi-conducteur InP. Le dièdre 6 des canaux s'étend légèrement en dessous du niveau de la jonction N-P, dans le substrat 1.

Les parties de la couche de masquage 3 en $SiO_2$ sont ensuite attaquées, avant que le substrat ne soit nettoyé et décapé (figure 4).

On dépose ensuite sur le substrat prégravé, une deuxième couche 7 de InP pour former une deuxième jonction P-N, et, dans les canaux 5, un fond arrondi 8 de InP-N, donc du même type que le substrat 1.

Le substrat 1 et les deux couches 2, 7 forment ainsi une jonction inverse N-P-N.

Sur la couche 7 et le fond 8, on dépose du phosphure et arséniure de gallium et d'indium InGaA$_s$P, à l'extérieur des canaux 5 sur la couche 7, sous forme d'une couche 9 d'épaisseur uniforme, et dans les canaux 5 sur le fond 8, sous forme d'une couche active 10 à section en forme de croissant. La forme en croissant de la couche 10 résulte de la croissance préférentielle de cette couche en raison ici encore de la structure cristallographique du matériau semi-conducteur InP. Il s'agit d'un croissant dit enterré.

Les compositions des bains liquides et la température à laquelle les dépôts sont effectués participent aussi à la formation du croissant 10 en lui conférant en outre des dimensions très faibles, en l'espèce une épaisseur sensiblement égale ou inférieure à 0,2 $\mu$m et une largeur sensiblement égale ou inférieure à 2 $\mu$m.

Les parois latérales 15 des canaux 5 en V s'étendent jusqu'à la couche 9, donc au-delà du niveau de la deuxième jonction P-N formée par les couches 2, 7.

Sur les couches 9, 10 on dépose ensuite une couche 11 de InP-P, puis, sur cette couche 11, une dernière couche de InGaA$_s$P fortement dopée en porteurs de type P.

En raison de la présence des deux interfaces InP (N)/ InGaA$_s$P et InGaA$_s$P/InP(P), on peut parler ici de diodes à double hétéro-structure.

Les diodes épitaxiées ainsi obtenues sont métallisées de façon connue de leurs côtés N et P, c'est-à-dire sur le substrat 1 et la couche 12.

On dépose ensuite sur la couche supérieure 12, sensiblement au droit des canaux 5, des bandes d'or et on soumet l'ensemble à l'action d'un implanteur protonique.

On ne décrira pas ici l'équipement d'implantation, celui-ci étant parfaitement connu de l'homme de métier. Rappelons seulement ici qu'un accélérateur accélère des ions et donc des protons produits par une anode et sélectionnés par un champ magnétique intense. Les bandes d'or arrêtent les protons qui ne s'implantent donc que dans les zones 13 des diodes disposées latéralement de part et d'autre des canaux 5 en V et de l'autre côté de ceux-ci par rapport au substrat, c'est-à-dire au-dessus de la couche 9, dans les couches 11 et 12 (figure 5).

L'implantation protonique rend les portions 13 considérées très résistives, ce qui les empêche d'être traversées par les lignes de courant.

On obtient ainsi des diodes laser à double confinement ou confinement renforcé, avec un premier confinement par jonction inverse et un deuxième confinement par implantation protonique : l'effet laser est parfaitement confiné dans la couche active en croissant 10.

Après un premier test de sélection en courant pulsé effectué sur les diodes, on découpe les plaquettes pour obtenir des puces qu'on soude sur un refroidisseur en cuivre avec de l'indium, et on procède à un deuxième test de sélection en courant continu.

Dans un exemple pratique de fabrication, la demanderesse a obtenu pour chacune des diodes les résultats suivants, $I_s$ étant le courant de seuil à 20°C en fonctionnement continu, $R_s$ la résistance série, $\eta$ le rendement quantique, et p la puissance lumineuse

$$30 \text{ mA} \leqslant I_s \leqslant 60 \text{ mA}$$

$$1,5 \, \Omega \leqslant R_s \leqslant 4 \, \Omega$$

$$\eta \geqslant 30 \, \%$$

$$p \simeq 7 \text{ mW}$$

On notera que les diodes de l'invention possèdent une bonne fiabilité, une sensibilité relativement faible à la température ($T_o$ de l'ordre de 70°K), des courants de seuil faibles et des rendements élevés, supérieurs à 80 % qui constituent autant d'avantages qui s'ajoutent encore à celui des diodes à confinement par jonction inverse de l'art antérieur.

8          **0161173**

Revendications

1. Diode laser à confinement électrique par jonction inverse, comprenant une première jonction, formée par un substrat semi-conducteur (1), de l'un des deux types de conductivité N et P, et une première couche (2) de l'autre des deux types, une deuxième jonction, formée par ladite première couche (2) et une deuxième couche (7) du même type que le substrat (1), un canal (5) en forme de V, et, enterrée dans le canal en V, au-dessus d'un fond (8) identique à ladite deuxième couche (7), une couche active (10) en forme de croissant, caractérisée par le fait que les portions (13) de la diode disposées lateralement de part et d'autre du canal (5) en V et de l'autre côté de celui-ci par rapport au substrat (1) sont implantées de protons.

2. Diode selon la revendication 1, dans laquelle le substrat (1), la première couche (2), la deuxième couche (7) et le fond (8) du canal (5), sont en phosphure d'indium InP.

3. Diode selon la revendication 2, dans laquelle la couche active (10) est en phosphure et arséniure de gallium et d'indium In Ga $A_s$ P.

4. Diode selon la revendication 3, dans laquelle, au-dessus de la couche active (10), sont disposées une couche (11) en InP et une couche (12) en In Ga $A_s$ P fortement dopée en porteurs de type P.

5. Diode selon la revendication 4, dans laquelle les protons sont implantés dans des zones (13) s'étendant dans les couches (11 et 12).

9

**0161173**

6. Diode selon l'une des revendications 1 à 5, caractérisée par le fait qu'elle émet un rayonnement laser de
1,3 µm de longueur d'onde.

7. Diode selon l'une des revendications 1 à 6, dans
laquelle le dièdre (6) du canal (5) en V s'étend légèrement en dessous du niveau de ladite première jonction,
et les parois latérales (15) du canal (5) s'étendent
au-delà du niveau de ladite deuxième jonction.

FIG.1

FIG.2

FIG.3

FIG.4

FIG.5

Office européen
des brevets

**RAPPORT DE RECHERCHE EUROPEENNE**

EP  85  40  0725

## DOCUMENTS CONSIDERES COMME PERTINENTS

| Catégorie | Citation du document avec indication. en cas de besoin des parties pertinentes | Revendication concernee | CLASSEMENT DE LA DEMANDE (Int. Cl. 4) |
|---|---|---|---|
| X | EP-A-0 096 613  (THOMSON-CSF) * Page 6, ligne 18 - page 8, ligne 22; page 9, lignes 1-14; revendications 1,2,4,5; figure 5 * | 1-7 | H 01 S   3/19 H 01 L  33/00 |
| | --- | | |
| Y | EP-A-0 061 938  (FUJITSU LTD.) * Résumé; page 6, ligne 11 - page 7, ligne 1; figures 2,6; revendications * | 1-4,6 | |
| A | | 7 | |
| | --- | | |
| Y | GB-A-2 095 474  (WESTERN ELECTRIC CO. INC.) * Résumé; page 2, lignes 8-34; page 2, ligne 61 - page 3, ligne 2; page 6, lignes 1-47; revendications 1,2,5,6; figures 7-9 * | 1-4,6 | **DOMAINES TECHNIQUES RECHERCHES (Int. Cl.4)** |
| A | | 5 | H 01 L H 01 S |
| | ---          -/- | | |

Le présent rapport de recherche a été établi pour toutes les revendications

| Lieu de la recherche | Date d achèvement de la recherche | Examinateur |
|---|---|---|
| LA HAYE | 17-07-1985 | VISENTIN A. |

Office européen
des brevets

RAPPORT DE RECHERCHE EUROPEENNE

0161173
Numéro de la demande

EP 85 40 0725

Page 2

## DOCUMENTS CONSIDERES COMME PERTINENTS

| Catégorie | Citation du document avec indication, en cas de besoin des parties pertinentes | Revendication concernée | CLASSEMENT DE LA DEMANDE (Int Cl.4) |
|---|---|---|---|
| A | IEEE JOURNAL OF QUANTUM ELECTRONICS, vol. QE-15, no. 7, juillet 1979, pages 571-579, IEEE, New York, US; M. YANO et al.: "Theoretical and experimental study of threshold characteristics in InGaAsP/InP DH lasers" * "Introduction"; section III, paragraphe A, "Samples"; figure 11 * | 1-6 | |
| A | FUJITSU SCIENTIFIC & TECHNICAL JOURNAL, vol. 18, no. 4, décembre 1982, pages 541-561, Kawasaki, JP; H. IMAI et al.: "V-grooved-substrate buried heterostructure InGaAsP/InP laser diodes" * Résumé; pages 542-543; pages 546-547; pages 555-556; figures 1,14 * | 1-4,6, 7 | |

DOMAINES TECHNIQUES RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 17-07-1985 | VISENTIN A. |